Europäisches Patentamt

European Patent Office

Office européen des brevets

(11) Veröffentlichungsnummer: **0 137 192**
A2

## (12) EUROPÄISCHE PATENTANMELDUNG

(21) Anmeldenummer: 84109367.7

(22) Anmeldetag: 07.08.84

(51) Int. Cl.4: **H 01 L 21/76**
H 01 L 21/32, H 01 L 21/318

(30) Priorität: 11.08.83 DE 3329074

(43) Veröffentlichungstag der Anmeldung:
17.04.85 Patentblatt 85/16

(84) Benannte Vertragsstaaten:
AT DE FR GB IT NL

(71) Anmelder: Siemens Aktiengesellschaft
Berlin und München Wittelsbacherplatz 2
D-8000 München 2(DE)

(72) Erfinder: Bussmann, Egon, Dr.
Josef-Vötter-Strasse 19
D-8000 München 90(DE)

(54) Verhinderung der Oxidationsmitteldiffusion bei der Herstellung von Halbleiterschichtanordnungen.

(57) Bei der Herstellung von Halbleiterschichtanordnungen ist der Verkleinerung der Feldoxidstrukturen durch die Länge des Dickoxidvogelschnabels eine Grenze gesetzt. Nach der Erfindung wird durch eine dünne Diffusionssperre aus Siliziumnitrid, die im gewünschten Temperaturbereich noch keine Kristallfehler erzeugt, die Oxidationsmitteldiffusion unterbunden. Durch Stickstoffimplantation und/oder spezielle Prozeßführung bei der Nitridabscheidung wird - falls erforderlich - auch das natürliche Oxid auf den Siliziumwafern in eine Diffusionssperre umgewandelt.

FIG 2

EP 0 137 192 A2

SIEMENS AKTIENGESELLSCHAFT
Berlin und München

Unser Zeichen
VPA 83 P 1 5 7 6 E

Verhinderung der Oxidationsmitteldiffusion bei der Herstellung von Halbleiterschichtanordnungen.

Die Erfindung betrifft eine Halbleiterschichtanordnung nach dem sogenannten LOCOS- oder Isoplanarverfahren mit einer dünnen Nitridschicht abgedeckt von einer Kombination aus Oxid- und Nitridschicht oder einer Polysiliziumschicht, die als Maskierung für eine anschließende Feldoxidstruktur dienen.

Der Verkleinerung der Feldoxidstrukturen ist durch die Länge des Dickoxidvogelschnabels eine Grenze gesetzt. Die minimale Länge ist bei gleicher Feldoxiddicke und Maskenschicht um so größer, je tiefer die Oxidationstemperatur liegt. Verwendet man Nitrid direkt auf Silizium als Maskierschicht (Siemens Forschungs- und Entwicklungsbericht, Band 10 (1981), Seiten 357 - 361), kann die Vergrößerung der minimalen Feldoxidbreite mit abnehmender Temperatur verhindert werden.

Stickstoffimplantation und thermische Nitrierung (Plasma enhanced) der Siliziumscheibe vor Erzeugung der Niox-Nitrid-Maskierschicht führt vor allem bei höheren Oxidations-Temperaturen ( $>950°C$ ) zu einem Verschwinden des Vogelschnabels bei Feldoxiddicken bis 0,5 µm. Diese Technologie ist in IEEE Transaction on Electron Devices, Vol. ED-29, No. 4, auf den Seiten 554 - 561 beschrieben.

Der Erfindung liegt die Aufgabe zugrunde, eine Halbleiterschichtanordnung zu schaffen, mit der feinste Strukturen ermöglicht und Prozeßschritte eingespart werden.

Wed 1 Plr/12.7.1983

Diese Aufgabe wird mit der eingangs definierten Halbleiterschichtanordnung dadurch gelöst, daß die auf dem Siliziumsubstrat aufgebrachte dünne Nitridschicht $<$ 50 nm eine Low-Pressure-Nitridschicht ist, auf die eine Zwischenschicht folgt, die von einer weiteren Nitridschicht abgedeckt ist. Dadurch wird das laterale Oxidwachstum begrenzt und damit eine Verkleinerung der Feldoxidstrukturen ermöglicht. Der der Verkleinerung der Feldoxidstrukturen entgegenstehende Dickoxidvogelschnabel wird damit verhindert. Der Vorteil dieser Ausführung liegt darin begründet, daß Low-Pressure-Nitrid wesentlich einfacher herzustellen ist als zum Beispiel thermisches Nitrid. Damit wird dann auch das Verfahren wesentlich vereinfacht.

Eine Weiterbildung der Erfindung besteht darin, daß die auf dem Siliziumsubstrat aufgebrachte dünne Nitridschicht eine mit Stickstoff implantierte Low-Pressure-Nitridschicht ist. Durch die Stickstoffimplantation wird unter der von LPCVD-Nitrid bedeckten natürlichen Oxidschicht eine reine Nitridschicht erzeugt.

Eine weitere Ausgestaltung der Erfindung besteht darin, daß die Zwischenschicht aus Polysilizium besteht. Die Polysiliziumschicht ist eine bessere Diffusionssperre gegen das Oxidationsmedium und kann gleichzeitig als Gate-Elektrode benutzt werden.

Das Verfahren zur Herstellung der Halbleiterschichtanordnung besteht darin, daß die Feldoxidation bei Temperaturen $\leqslant$ 850°C und Drücken $\geqslant$ 1 bar erfolgt. Der Vorteil der Niedrigtemperaturoxidation liegt im verringerten Wachstum von Kristallfehlern.

Im Rahmen der Erfindung kann ferner das Polysilizium als Gate-Elektrode für Transistoren und/oder Speicherkapazitäten verwendet werden.

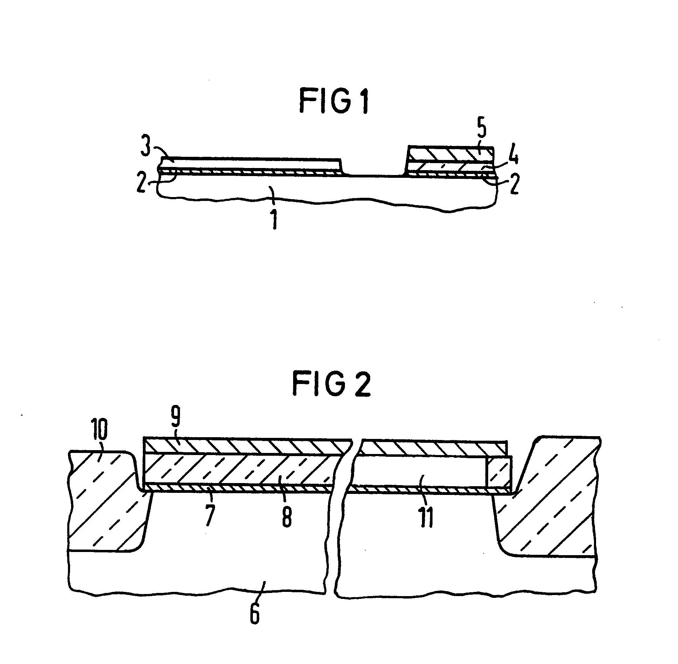

Die Erfindung wird anhand der Figur 2 erläutert. Es zeigen:

Figur 1 zwei Varianten des Standes der Technik und

Figur 2 die erfindungsgemäßen Merkmale an einem Ausführungsbeispiel.

Bei der linken Variante der Figur 1 ist durch Plasma unterstützte thermische Nitrierung bzw. Niederspannungsimplantation auf einem Siliziumsubstrat 1 eine dünne Nitridschicht 2 erzeugt worden, die durch Polysilizium 3
abgedeckt ist.

Bei der rechten Variante ist die Nitridschicht 2 durch
eine Kombination von Siliziumoxid 4 und Low-Pressure-
Nitrid 5 - wie in herkömmlichen Verfahren (LOCOS-Technik)
üblich - bedeckt.

In der Figur 2 ist in der linken Hälfte auf dem Siliziumsubstrat 6 eine Low-Pressure-Nitridschicht 7 abgeschieden
und mit Stickstoff implantiert. Darauf folgt eine Siliziumoxidschicht 8, die wiederum von einer Siliziumnitridschicht 9 abgedeckt ist. Mit 10 ist die Feldoxidstruktur
angedeutet, die keinen Vogelschnabel erkennen läßt.

In der rechten Hälfte der Figur 2 ist die Siliziumschicht
durch Polysilizium 11 ersetzt. Die Nitridschicht unter
dem Polysilizium benötigt nicht die Stickstoffimplantation.

Das Aufwölben der Maskenkanten wird durch eine die Nitridschicht bedeckende Doppelschicht zur Verhinderung von
Spannungen im Silizium verhindert. Die Doppelschichten
bestehen, wie anhand der Figur 2 erläutert wurde, aus
Polysilizium/Nitrid oder Siliziumoxid/Nitrid.

5 Patentansprüche
2 Figuren

Patentansprüche

1. Halbleiterschichtanordnung nach dem sogenannten LOCOS-oder Isoplanarverfahren mit einer dünnen Nitridschicht abgedeckt von einer Kombination aus Oxid und Nitridschicht oder aus einer Polysiliziumschicht, die als Maskierung für eine anschließende Feldoxidstruktur dienen, d a d u r c h   g e k e n n z e i c h n e t , daß die auf dem Siliziumsubstrat (6) aufgebrachte dünne Nitridschicht (2) $<$ 50 nm eine Low-Pressure-Nitridschicht ist, auf die eine Zwischenschicht (8) folgt, die von einer weiteren Nitridschicht (9) abgedeckt ist.

2. Halbleiterschichtanordnung nach Anspruch 1, d a - d u r c h   g e k e n n z e i c h n e t , daß die auf dem Siliziumsubstrat (6) aufgebrachte dünne Nitridschicht (7) eine mit N-implantierte Low-Pressure-Nitridschicht ist.

3. Verfahren nach Anspruch 1, d a d u r c h   g e - k e n n z e i c h n e t , daß die Zwischenschicht aus Polysilizium (11) besteht.

4. Verfahren zur Herstellung der Halbleiterschichtanordnungen nach den Ansprüchen 1 bis 3, d a d u r c h   g e k e n n z e i c h n e t , daß die Feldoxidation bei Temperaturen $\leqslant$850°C und Drücken $\geqslant$1 bar erfolgt.

5. Verfahren nach Anspruch 3, d a d u r c h   g e - k e n n z e i c h n e t , daß das Polysilizium (7) als Gateelektrode für Transistoren und/oder Speicherkapazitäten verwendet wird.

1/1

FIG 1

FIG 2